(19) Europäisches Patentamt
European Patent Office
Office européen des brevets

(11) **EP 2 845 018 B1**

(12) **EUROPEAN PATENT SPECIFICATION**

(45) Date of publication and mention of the grant of the patent:
**20.06.2018   Bulletin 2018/25**

(51) Int Cl.:
*G01R 31/00* (2006.01)          *G04F 10/10* (2006.01)
*G01R 21/00* (2006.01)          *G01R 19/15* (2006.01)
*G01K 13/00* (2006.01)

(21) Application number: **13782143.5**

(22) Date of filing: **27.04.2013**

(86) International application number:
**PCT/CN2013/074864**

(87) International publication number:
**WO 2013/159743 (31.10.2013 Gazette 2013/44)**

(54) **METHOD FOR DETECTING POWER INTERRUPTION DURATION OF AN ELECTRONIC DEVICE**

VERFAHREN ZUR DETEKTION DER STROMUNTERBRECHUNGSDAUER EINER ELEKTRONISCHEN VORRICHTUNG

PROCÉDÉ DE DÉTECTION DE LA DURÉE D'INTERRUPTION DE L'ALIMENTATION D'UN DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **27.04.2012   CN 201210128272**

(43) Date of publication of application:
**11.03.2015   Bulletin 2015/11**

(73) Proprietors:
• **Mettler Toledo (Changzhou) Precision Instrument Ltd.**
  **Changzhou, Jiangsu 213022 (CN)**
• **Mettler Toledo (Changzhou) Measurement Technology Ltd.**
  **Jiangsu 213125 (CN)**
• **Mettler Toledo (Changzhou) Scale&System Ltd.**
  **Changzhou, Jiangsu 213125 (CN)**

(72) Inventors:
• **XIE, Guojun**
  **Changzhou, Jiangsu 213022 (CN)**

• **XIA, Guangping**
  **Changzhou, Jiangsu 213022 (CN)**
• **YU, Jingquan**
  **Changzhou, Jiangsu 213022 (CN)**

(74) Representative: **Mettler-Toledo**
**IP Department**
**Im Langacher 44**
**8606 Greifensee (CH)**

(56) References cited:
**EP-A1- 0 819 945          WO-A1-00/20931**
**CN-A- 101 629 845          CN-A- 102 122 146**
**CN-A- 102 628 907          JP-B2- H0 535 372**
**US-A1- 2011 119 002**

• **ZHAO, JINXIAN ET AL.: 'Study on The Question of Time Record for PLC Service Interruption' JOURNAL OF JIXI UNIVERSITY vol. 1, no. 1, March 2001, page 52,53,55, XP008175466**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present disclosure relates to a method for detecting power interruption duration of an electronic device, and belongs to the technical field of detecting interruption duration of an electronic device.

So far, a variety of electronic devices, such as electronic scales, electronic balances, digital sensors and automatic control devices, are widely used in various industries. These electronic devices are comprised of device carrier, printed circuit board, cables and so on. In use of some electronic devices, when the electronic devices are powered on, it is needed to know power interruption duration of the devices, for diagnosis of initial state of the devices at power on and compensation for thermal deformation error, or for preheat compensation of the electronic devices during a period after power on. It is much more important to record the power interruption duration of the electronic devices especially in the situation that the devices are subjected to power interruption and power on frequently.

In WO 00/20931 A1 a method for estimating the duration of the interruptions in the supply from the electric mains in an electric appliance having an electronic control, in particular a household appliance, is disclosed and includes the steps of (a) on the occasion of an interruption of the supply voltage of the apparatus, measuring and storing the value of at least one quantity that is characteristic of the operating status of the apparatus; (b) on the occasion of the restoration of the supply voltage, measuring the current value of the at least one characteristic quantity; (c) comparing the stored value and the current value of the at least one characteristic quantity; and (d) estimating, on the basis of the comparison, the duration of the interruption of the supply voltage.

A conventional method of recording power interruption duration is to employ a RTC (Real Time Clock) to record the power interruption duration. So far, there are two kinds of RTC; one is a battery-powered disposable RTC, and the other is a rechargeable RTC (or named "Super capacitor") which can be reused for many times.

So far, there are the following disadvantages with RTC (Real Time Clock) in recording power interruption duration:

1) Complexity and cost of the circuit is increased, because an RTC needs coordination of external circuits;
2) When recording the power interruption duration, a RTC writes point-in-time data into a non-volatile memory continuously, which greatly affects the capacity and read-write lifespan of the non-volatile memory. Once the non-volatile memory does not work, the RTC would lose its timing function;
3) Performance of the electronic device will be affected due to the high power consumption during recharging of the RTC;
4) Discharge time of the RTC is limited, and when the RTC runs out of battery, it no longer has timing function;
5) When an RTC works at a low voltage, timing thereof will be inaccurate, which is less reliable.

The present invention aims to provide a method for detecting power interruption duration of an electronic device that is not limited by discharge time, is accurate in timing, and does not affect performance of the electronic device.

To achieve the above objectives, the technical solution of the present invention is a method for detecting power interruption duration of an electronic device according to independent method claim 1. This method comprises:

(1) establishing a curve model of a linearly synthesized values of temperature sensor readings versus time, and writing it into a microprocessor as firmware, said curve model of a linearly synthesized values of temperature sensor readings versus time is represented as:

$$ST = \sum_{i=1}^{n} k_i \cdot [a_{0i} + a_{1i}(1 - 1/e^{(t/C_i)})]$$

in which: $ST$ is a linearly synthesized value of temperature sensor readings; $n$ is a number of the temperature sensors, $n \geq 2$; $k_i$ is a synthesized coefficient of the temperature value; and $k_i$ is controlled to be $-1 < k_i < 1$, and $k_i \neq 0$; $a_{0i}$ is an initial temperature value acquired by a temperature sensor; $a_{1i}$ is a scaling factor of a temperature sensor output, and $a_{1i}$ is controlled to be $-200 < a_{1i} < 200$, and $a_{1i} \neq 0$; $C_i$ is a time constant, and $1 \leq C_i \leq 10000$; and $t$ is a power-on duration or power-interruption duration (s), wherein the power-on duration is represented by $t_p$, and the power-interruption duration is represented by $t_o$;

(2) the electronic device is provided with at least one temperature sensor for detecting temperature of the electronic device and at least one temperature sensor for detecting temperature of a printed circuit board;

(3) after power-on of the electronic device, conveying each acquired initial temperature value $a_{0i}$ by a respective temperature sensor to a microprocessor through an analog-to-digital conversion module; processing each acquired initial temperature value $a_{0i}$ by the microprocessor to filter out an interfering signal, while recording a power-on duration $t_p$ for this time by the microprocessor; calculating the linearly synthesized value $ST$ of the temperature sensor readings of the electronic device for this time with the stored curve model, and storing the linearly synthesized value *ST* of the temperature sensor readings within the microprocessor as a basis for calculating the power interruption duration $t_o$ thereafter;

(4) when the electronic device is powered on again after power interruption, conveying each initial temperature value reacquired by the temperature sensors to the microprocessor through the analog-to-digital conversion module; processing each acquired initial temperature value $a_{0i}$ by the microprocessor to filter out an interfering signal; reading by the microprocessor the linearly synthesized value *ST* of the temperature sensor readings stored at a previous time; calculating the power interruption duration $t_o$ for this time with the curve model of the linearly synthesized values of temperature sensor readings versus time and storing the power interruption duration $t_o$ for this time, while recording the power-on duration $t_p$ for this time; calculating the linearly synthesized value *ST* of the temperature sensor readings of the electronic device for this time, and storing the linearly synthesized value *ST* of the temperature sensor readings within the microprocessor as a basis for calculating the power interruption duration $t_o$ again thereafter, wherein when the power interruption duration $t_o$ is greater than a critical value, the power interruption duration $t_o$ is the critical value.

The present invention writes the established curve model of the linearly synthesized values of temperature sensor readings versus time into the microprocessor as firmware, detects the initial temperature value at each measuring site of the electronic device by respective temperature sensor after power-on of the electronic device, obtains the linearly synthesized value *ST* of the temperature sensor readings of the electronic device for this time as a basis for calculating the power interruption duration $t_o$ thereafter, detects the initial temperature value of the electronic device again by respective temperature sensors after the electronic device is powered on again after power interruption, reads the linearly synthesized value *ST* of the temperature sensor readings stored at a previous time and calculates the power interruption duration $t_o$ of the electronic device for this time. Since the temperature sensors are directly connected to the printed circuit board without coordination of an external circuit, it is simple to implement.

Further, after the electronic device is powered on, the temperatures sensor can function normally as long as the printed circuit board can function normally, which is excellent in stability. In addition, when the electronic device is powered off the temperature sensors stop functioning, thus the temperature sensors have longer lifetime and does not have the disadvantage of limited discharge time as with an RTC. By reading the initial temperature value of the temperature sensors at power on, the present invention calculates the power interruption duration $t_o$ for this time based on the linearly synthesized value *ST* of the temperature sensor readings of the electronic device stored at a previous time. There is no need to write the data into the non-volatile memory continuously, which saves memory resources and brings high reliability.

The present invention does not involve the charging and discharging process of an RTC, which brings low power consumption and does affect the printed circuit board and overall performance of the electronic device. The present invention employs an established curve model of linearly synthesized values of temperature sensor readings versus time, wherein the same curve model is used for power-on duration $t_p$ and power interruption duration $t_o$, and the linearly synthesized value of temperature sensor readings at a previous time is employed for calculating the power interruption duration for this time. Such a configuration is less intensive in computation, less difficult in software implementation, less intensive in system resource occupation and is easy to implement.

Embodiments of the present invention disclosed herein will be described in further detail in conjunction with the accompanying drawings, wherein:

Fig. 1  is a flow diagram of an exemplary method of detecting a power interruption duration of electronic device according to the present invention;

Fig. 2  is a graph showing linearly synthesized values of temperature sensor readings versus time according to the present invention;

Fig. 3  is a schematic diagram showing configuration of an electronic weighing device in which the method of detecting power interruption duration of electronic device according to the present invention is implemented; and

Fig. 4  is a schematic diagram showing configuration of a numerically-controlled machine tool in which the method of detecting a power interruption duration of electronic device according to the present invention is implemented.

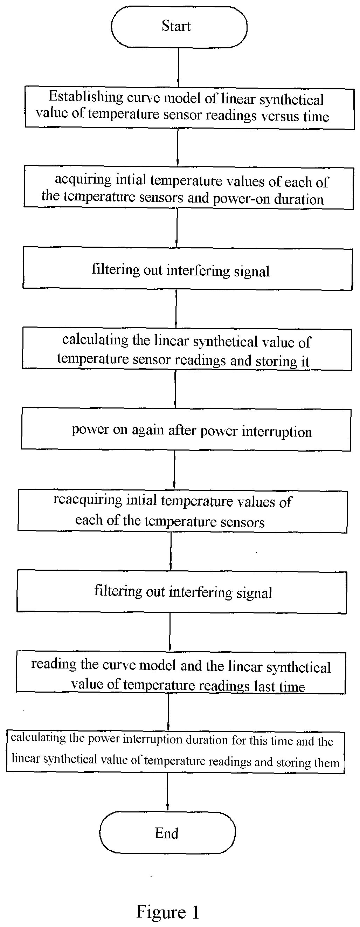

As shown in Figure 1, the method of detecting a power interruption duration of electronic device according to the present invention comprises:

(1) establishing a curve model of linearly synthesized values of temperature sensor readings versus time, and writing the curve model into a microprocessor as firmware, said curve model of linearly synthesized values of temperature sensor readings versus time is represented as:

$$ST = \sum_{i=1}^{n} k_i \cdot [a_{0i} + a_{ji}(1 - 1/e^{(t/C_i)})]$$

in which:

*ST* is a linearly synthesized value of the temperature sensor readings;

$n$ is a number of the temperature sensors, $n \geq 2$;

$k_i$ is a synthesized coefficient of a temperature value, and $k_i$ is controlled to be $-1 < k_i < 1$, and $k_i \neq 0$;

$a_{0i}$ is an initial temperature value acquired by a temperature sensor;

$a_{1i}$ is a scaling factor of a temperature sensor output, and $a_{1i}$ is controlled to be $-200 < a_{1i} < 200$, and $a_{1i} \neq 0$;

$C_i$ is a time constant, and $1 \leq C_i \leq 10000$; and

t is a power-on duration or power-interruption duration (s), wherein the curve model is represented as

$$ST = \sum^{n} k_i \cdot [a_{0i} + a_{1i}(1 - 1/e^{(t_p/C_i)})] \quad \text{for}$$

power-on duration represented by $t_p$, and the curve model is represented as

$$ST = \sum^{n}_{i=1} k_i \cdot [a_{0i} + a_{1i}(1 - 1/e^{(t/C_i)})] \quad \text{for pow-}$$

er-interruption duration represented by $t_o$.

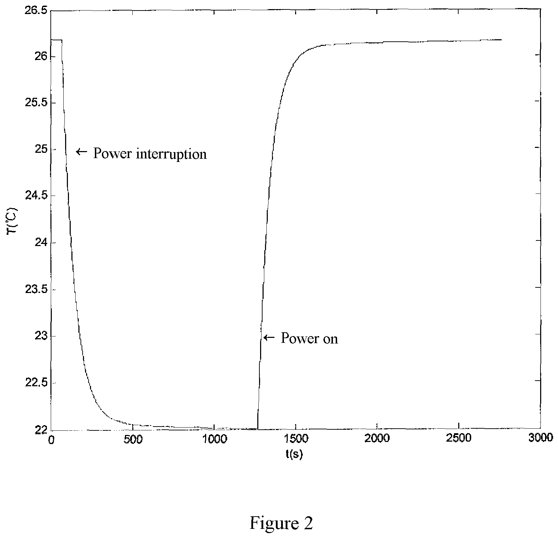

In the above representation, $k_i$, $a_{1i}$ and $C_i$ are all dependent on the temperature sensors. The number of the installed temperature sensors is not limited. As shown in Figure 2, the graph of the linearly synthesized values of temperature sensor readings versus time according to the present invention applies to both a power-on situation and a power-interruption situation, thus the load of calculation is reduced.

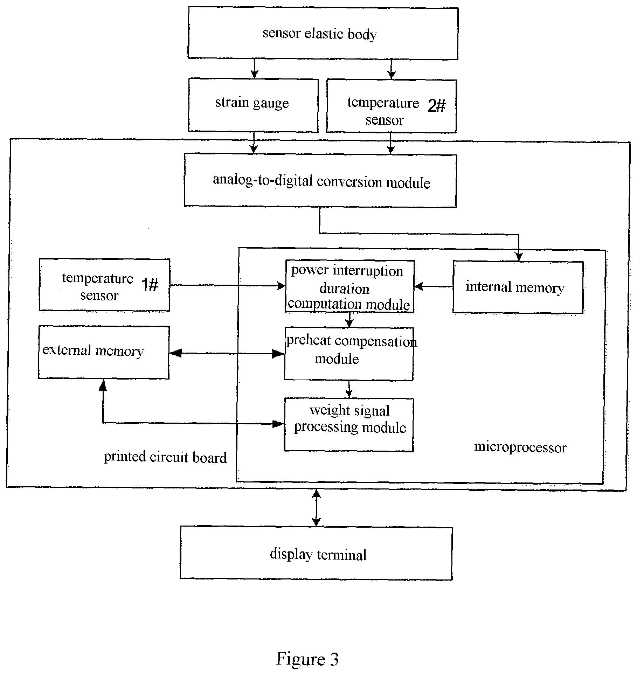

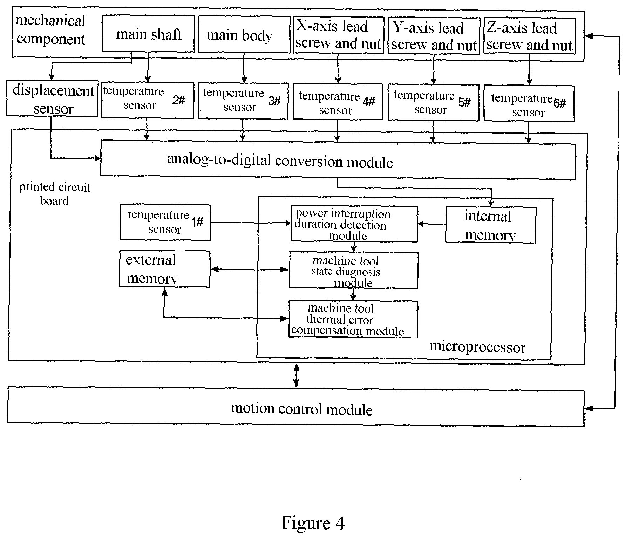

The electronic device is provided with at least one temperature sensor for detecting temperature of the electronic device and at least one temperature sensor for detecting temperature of the printed circuit board, wherein the temperature sensors are mounted at moving sites and heat-generating sites of the electronic device. As shown in Figure 3, one temperature sensor is mounted on a digital weighing sensor, and another temperature sensor is mounted on the printed circuit board. As shown in Figure 4, the temperature sensors are mounted on main shaft, main body, X-axis lead screw and nut, Y-axis lead screw and nut, Z-axis lead screw and nut of the machine tool, respectively, at sites which can reflect a temperature distribution of the device. These temperature sensors may be mounted internal or external to the electronic device, and may be disposed depending on the configuration of the electronic device.

After power-on of the electronic device, conveying each acquired initial temperature value $a_{0i}$ to a respective temperature sensor to a microprocessor through an analog-to-digital conversion module; processing each acquired initial temperature value $a_{0i}$ by the microprocessor to filter out an interfering signal, while recording a power-on duration $t_p$ for this time by the microprocessor; calculating the linearly synthesized value $ST$ of the temperature sensor readings of the electronic device for this time with the stored curve model, and storing the linearly synthesized value $ST$ of the temperature sensor readings within the microprocessor as a basis for calculating the power interruption duration $t_o$ thereafter.

When the electronic device is powered on again after power interruption, conveying each initial temperature value $a_{0i}$ reacquired by the temperature sensors to the microprocessor through the analog-to-digital conversion module; processing each acquired initial temperature value $a_{0i}$ by the microprocessor to filter out an interfering signal; reading by the microprocessor the linearly synthesized value $ST$ of the temperature sensor readings stored at a previous time; calculating the power interruption duration $t_o$ for this time with the curve model of the linearly synthesized values of temperature sensor readings versus time and storing the power interruption duration $t_o$ for this time, while recording the power-on duration $t_p$ for this time; calculating the linearly synthesized value $ST$ of the temperature sensor readings of the electronic device for this time, and storing the linearly synthesized value $ST$ of the temperature sensor readings for this time within the microprocessor as a basis for calculating the power interruption duration $t_o$ again thereafter; repeating the above steps, such that the power interruption duration for each time can be calculated precisely. When the power interruption duration $t_o$ is greater than a critical value, the power interruption duration $t_o$ is the critical value, wherein the critical value of the power interruption duration $t_o$ is between 1.5h to 9h.

Figure 3 shows an electronic weighing device in which a method of detecting power interruption duration of an electronic device according to the present invention is implemented. The electronic device is mainly comprised of sensor elastic body, resistive strain gauge and printed circuit board, wherein the printed circuit board is mainly comprised of a microprocessor, analog-to-digital conversion module, external memory and other peripheral circuits. The resistive strain gauge is connected with the sensor elastic body such that when weight is loaded on the sensor elastic body, deformation of the sensor elastic body will be transformed into an analog signal of voltage change of the resistive strain gauge. Such an analog signal is transmitted to the printed circuit board, and is converted to a digital weight signal by the analog-to-digital conversion module therein. The digital weight signal with noise is transmitted to an internal memory within the microprocessor, then to a digital weight signal processing module for digital signal processing to be a stable and reliable weight signal. The final stable weight signal is sent to the display terminal by the digital weighing sensor.

The method of detecting power interruption duration of an electronic device according to the present invention may be applied to a digital weighing sensor for preheat compensation of the digital signal. According to provisions of International Specification OIML-R60 and GB/T 7551-2008, there are specifications (i.e. requirements) of preheat duration and preheat parameters for a digital weighing sensor. In some applications, an electronic scale or balance is to be capable of weighing immediately after power-on. Thus, the digital weighing sensor should function normally after power-on, such that a preheat error of the sensor does not exceed a maximum tolerance. In such context, the digital weighing sensor is to be capable of preheat compensation.

An initial temperature value of the sensor elastic body is acquired by a temperature sensor No. 2 fixed on the sensor elastic body, and is converted by the analog-to-digital conversion module to a digital temperature signal, which is stored in an internal memory of the microprocessor. An initial temperature value of the printed circuit board is acquired by a temperature sensor No.1 fixed on the printed circuit board proximate to the microprocessor, and is converted to a digital temperature signal, which is transmitted to a power interruption duration detection module of the microprocessor

With the method of detecting power interruption duration embedded into the power interruption duration detection module, when the digital weighing sensor is powered on, the power interruption duration detection module reads initial temperature values from both temperature sensors, and calculates power interruption duration of the digital weighing sensor based on the linear relationship of the numerical values of the two temperature sensors, and output the power interruption duration to a preheat compensation module. Upon receiving the power interruption duration signal and digital weight signal, the preheat compensation module will perform preheat compensation on the weight signal to eliminate the impact of preheat on the digital weighing sensor. The compensated digital weight signal is delivered to the weight signal processing module for temperature compensation, creep compensation, lag compensation or linear compensation, and becomes a weight signal with high precision. Such weight signal is sent to a display terminal which is an instrument, electronic scale or other display device.

After the digital weighing sensor is powered on, the power interruption detection module operates to acquire an initial temperature value $a_{01}$ of the temperature sensor No. 1 on the printed circuit board and an initial temperature value $a_{02}$ of the temperature sensor No. 2 fixed on the sensor elastic body with an acquiring frequency no less than the updating frequency of the digital weight signal, then filter out interfering signal (especially high frequency interfering signal), and normalize the temperature data for ease of floating point calculation. Upon recording the power-on duration $t_p$ by the microprocessor, the power interruption duration detection module 9 calculates the linearly synthesized value $ST$ of the temperature sensor readings with

$$ST = \sum_{i=1}^{n} k_i \cdot [a_{0i} + a_{ij}(1 - 1/e^{(t/C_i)})]$$

Since two temperature sensors are employed, the linearly synthesized value of the temperature sensor readings is represented as
$ST = k_1 \cdot [a_{01} + a_{11}(1 - 1/e^{(t/C_1)})] + k_2 \cdot [a_{02} + a_{12}(1 - 1/e^{(t/C_2)})]$.
The linearly synthesized value $ST$ of the temperature sensor readings is stored in an internal memory of the microprocessor, and is used as a basis for calculating the power interruption duration $t_o$ thereafter when powered on again.

When the weighing device is powered on again after power interruption, the power interruption detection module operates to reacquire an initial temperature value $a_{02}$ of the temperature sensor No. 2 fixed on the sensor elastic body and an initial temperature value $a_{01}$ of the temperature sensor No. 1 on the printed circuit board, read the linearly synthesized value $ST$ of the temperature sensor readings previously stored in an internal memory of the microprocessor, synthesized coefficients $k_1$, $k_2$ of the temperature value of both temperature sensors, scaling factors $a_{11}$, $a_{12}$ of the temperature sensor output of both temperature sensors and time constants $C_1$, $C_2$ of both temperature sensors. With the values $ST$, $a_{0i}$, $a_{1i}$, $C_i$, $k_i$ determined, the power interruption duration $t_o$ of the electronic device for this time may be calculated by an iteration method such as the Newton iteration method using the same curve model of the linearly synthesized values of temperature sensor readings versus time, and may be stored in external memory for preheat compensation. In the meantime, the microprocessor records the power-on duration $t_p$ for this time, calculate the linearly synthesized value $ST$ of the temperature sensor readings, and store it in the microprocessor as a basis for calculating the power interruption duration $t_o$ thereafter.

Repeating the above steps, the power interruption duration for each time can be calculated more and more precisely. The critical value of the power interruption duration $t_o$ according to the present invention is between 1.5h to 2.5h. When the power interruption duration $t_o$ is greater than a critical value of 1.5h, 2h or 2.5h, the power interruption duration $t_o$ is 1.5h, 2h or 2.5h.

The method of detecting power interruption duration of the present invention applies not only to a digital weighing sensor, but also to electronic devices or high-precision sensors that require preheat compensation, such as an electronic scale, electronic balance, electronic flow sensor, infrared sensor and laser jet.

Figure 4 shows a numerically-controlled machine tool in which the method of detecting power interruption duration of electronic device according to the present invention is implemented. The machine tool is mainly comprised of mechanical components, a printed circuit board and a motion control module. The mechanical components of the machine tool is the actuating component, which is mainly comprised of main shaft, main body, X-axis lead screw and nut, Y-axis lead screw and nut, Z-axis lead screw and nut and cooling module. The printed circuit board is used for thermal error compensation and troubleshooting, and is mainly comprised of microprocessor, analog-to-digital conversion module, external memory and other peripheral circuits. When the machine tool is powered on for operation, the printed circuit board determines whether the machine tool is in a normal state. If so, the numerically-controlled machine tool starts operation, and the motion control module receives the thermal error compensation signal from the printed circuit board and sends the compensated motion control to actuating components, to control motion of the main shaft and other mechanical components with precision for precise machinery operation such as precise cutting.

The method of detecting power interruption duration of electronic device according to the present invention may be applied to the compensation for thermal deformation error (for short, "thermal error") in a numerically-controlled machine tool. Thermal error is a key factor which affects stability of the machining precision of the machine tool, and is a major error source for precision machine such as numerically-controlled machine tool. Since a numerically-controlled machine tool generates heat inevitably in operation, especially in some high speed machining applications where the main shaft speed and feed speed are high, the thermal deformation of the machine tool structure and tracking error of the position control increase. Thus, thermal error compensation is required for a numerically-controlled machine tool, especially for numerically-controlled machine tool with high precision.

After power on of the numerically-controlled machine tool, it generally does not work well until it has operated for a period of time. The period of time depends on the power interruption duration $t_o$ of the machine tool. Since the initial operation state of the machine tool also depends on the power interruption duration $t_o$ of the machine tool and the initial operation state has to be taken into account in thermal error compensation, the power interruption duration $t_o$ of the machine tool has to be taken into account in thermal error compensation.

Temperature sensor No. 2 is fixed on a suitable position of the main shaft of the machine tool, for acquiring initial temperature values of the main shaft. Temperature sensor No. 3 is fixed on a suitable position of the main body of the machine tool, for acquiring initial temperature values of the main body. Temperature sensors No.4, No.5 and No.6 are fixed on suitable positions on X, Y, Z lead screws and nuts of the machine tool, for acquiring initial temperature values of the X, Y, Z lead screws and nuts respectively. The initial temperature values acquired by these temperature sensors are converted to digital temperature signals by analog-to-digital conversion module and the digital temperature signals are stored in internal memory of the microprocessor. Temperature sensor No.1 is fixed on the printed circuit board proximate to the microprocessor, for acquiring initial temperature values of the printed circuit board. The initial temperature values of the printed circuit board are converted to digital temperature signal and the digital temperature signal are transmitted to the power interruption duration detection module of the microprocessor.

Upon power-on of the numerically-controlled machine tool, the power interruption duration detection module reads simultaneously an initial temperature value of the temperature sensor No. 1 and initial temperature values of the temperature sensors No. 2-6 stored in the internal memory, then filters out an interfering signal (especially high frequency interfering signal), and normalizes the temperature data for ease of floating point calculation. Upon recording the power-on duration $t_p$ by the microprocessor, the power interruption duration detection module calculates the linearly synthesized value $ST$ of the temperature sensor readings with

$$ST = \sum_{i=1}^{n} k_i \cdot [a_{0i} + a_{1i}(1 - 1/e^{(t/C_i)})] \quad ,$$

wherein the number n of the temperature sensors is 6. The calculated linearly synthesized value $ST$ of the temperature sensor readings is stored in an internal memory of the microprocessor, and is used as a basis for calculating the power interruption duration $t_o$ thereafter when powered on again.

When the weighing device is powered on again after power interruption, the power interruption detection module operates to reacquire the initial temperature values of the temperature sensors No. 2-6 fixed on the machine tool and the initial temperature value of the temperature sensor No. 1 on the printed circuit board, read the linearly synthesized value $ST$ of the temperature sensor readings previously stored in the internal memory of the microprocessor, synthesized coefficient $k_i$ of the temperature value of each of the temperature sensors, scaling factor $a_{1i}$ of the temperature sensor output of each of the temperature sensors and time constant $C_i$ of each of the temperature sensors. With the values $ST$, $a_{0i}$, $a_{1i}$, $C_i$, $k_i$ determined, the power interruption duration $t_o$ of the machine tool for this time may be calculated by an iteration method such as the Newton iteration method using the same curve model of the linearly synthesized values of temperature sensor readings versus time, and may be stored in external memory.

The initial temperature values of each of the temperatures and the power interruption duration $t_o$ of the machine tool are output together to a machine tool state diagnosis module. Upon receiving the initial temperature values of each of the temperatures, the deformation signal of the main shaft of the machine tool from a displacement sensor and the power interruption duration $t_o$ of the machine tool, the machine tool state diagnosis module reads diagnosis model and parameters in the external memory to diagnose an operation state of the numerically-controlled machine tool for this time and determine whether the machine tool is in a normal state. If not, precaution information is given and the operation of the machine tool paused.

If the state of the machine tool is determined as normal by the machine tool diagnosis module, the power interruption duration $t_o$, deformation of the machine tool and temperature information of each of the temperature sensors are transmitted to the thermal error compensation module of the machine tool. Subsequently, the thermal error compensation module of the machine tool reads compensation model and parameters stored in external memory, and calculates a thermal error compensation amount based on a power interruption duration of the machine tool, temperature information of each component, initial deformation of the machine tool and the like. The thermal error compensation amount is sent to a numerical control system of the machine tool to eliminate the impact of thermal deformation on machining precision of the machine tool, thus achieving stability for the precision machining of the numerically-controlled machine tool.

In the meantime, the microprocessor records the power-on duration $t_p$ for this time, calculates the linearly synthesized value $ST$ of the temperature sensor readings of the machine tool and stores it in the microprocessor as a basis for calculating the power interruption duration $t_o$ thereafter. Repeating the above steps, the power interruption duration for each time can be calculated more and more precisely. The critical value of the power interruption duration $t_o$ according to the present invention is between 5h to 9h. When the power interruption duration $t_o$ is greater than a critical value of 6h, 7h or 8h, the power interruption duration $t_o$ is 6h, 7h or 8h.

The present invention presents a method of calculating a power interruption duration $t_o$ of a numerically-controlled machine tool based on the relationship of several temperature sensors distributed at representative sites for measuring temperature in the machine tool, in order to realize thermal compensation. The method may be applied to not only a numerically-controlled machine tool, but also to all electronic-mechanical machining tools with high precision which require thermal error compensation, such as CNC machining center, high-precision robotic arms.

**Reference signs list**

| | |
|---|---|
| $ST$ | linearly synthesized values of temperature sensor readings |
| $n$ | number of the temperature sensors |
| $k_i$ | synthesized coefficient of the temperature value |
| $a_{0i}$ | initial temperature value |
| $a_{1i}$ | scaling factor of a temperature sensor output |
| $C_i$ | time constant |
| $t$ | duration [sec.] |
| $t_p$ | power-on duration |
| $t_o$ | power-interruption duration |

**Claims**

1. Method for detecting power interruption duration ($t_0$) of an electronic device which is provided with at least one temperature sensor for detecting temperature of the electronic device and at least one temperature sensor for detecting temperature of a printed circuit board, the method comprising the steps of:

(1) establishing a curve model of linearly synthesized values (ST) of temperature sensor readings versus time;
(2) storing the curve model in an internal memory of the microprocessor;
(3) conveying, after power-on of the electronic device, each acquired initial temperature value ($a_{0i}$) by a respective temperature sensor to a microprocessor through an analog-to-digital conversion module;
(4) calculating the linearly synthesized value (ST) of the electronic device for this time with the stored curve model established in step 1, and storing the linearly synthesized value (ST) within the microprocessor as a basis for calculating the power interruption duration ($t_0$) thereafter;
(5) conveying, when the electronic device is powered on again after power interruption, each initial temperature value ($a_{0i}$) reacquired by the temperature sensors to the microprocessor through the analog-to-digital conversion module;
(6) calculating the power interruption duration (t0) for this time with the curve model established in step 1 and based on the linearly synthesized value (ST) stored in the microprocessor calculated in step 4, and storing the power interruption duration ($t_0$) for this time, while recording the power-on duration (tp) for this time by the microprocessor;
(7) calculating the linearly synthesized value (ST) for this time, and storing the linearly synthesized value (ST) within the microprocessor as a basis for calculating the power interruption duration ($t_0$) again thereafter

**characterized in that** the curve model of linearly synthesized values (ST) of temperature sensor readings versus time is represented as:

$$ST = \sum_{i=1}^{n} k_i \cdot [a_{0i} + a_{1i}(1 - 1/e^{(t/C_i)})]$$

in which:

$ST$ is a linearly synthesized value of temperature sensor readings;

$n$ is a number of the temperature sensors, $n \geq 2$;
$k_i$ is a synthesized coefficient of the temperature value; and $k_i$ is controlled to be

$$-1 < k_i < 1 \text{ and } k_i \neq 0 ;$$

$a_{0i}$ is an initial temperature value acquired by a temperature sensor;
$a_{1i}$ is a scaling factor of a temperature sensor output, and $a_{1i}$ is controlled to be

$$-200 < a_{1i} < 200 \text{ and } a_{1i} \neq 0 ;$$

$C_i$ is a time constant, $-1 \leq C \leq 10000$ ; and
$t$ is a power-on duration or power-interruption duration, wherein the power-on duration is represented by $t_p$, and the power-interruption duration is represented by $t_o$.

**2.** Method according to claim 1, wherein when the power interruption duration ($t_0$) is greater than a specified value, the power interruption duration (t0) is designated as a critical value.

**3.** Method according to claim 1 or 2, wherein the temperature sensors are mounted at moving sites and/or heat-generating sites of the electronic device.

**4.** Method according to any of the claims 2 to 3, wherein the critical value of the power interruption duration ($t_0$) is between 1.5h to 9h.

**5.** Method according to any of the claims 1 to 4, further comprising the step of:

- writing the established curve model of the linearly synthesized values (ST) of temperature sensor readings versus time into the microprocessor as firmware.

**6.** Method according to any of the claims 1 to 5, further comprising the step of:

- filtering out an interfering signal while recording a power-on duration ($t_p$) for this time by processing each acquired initial temperature value ($a_{0i}$)

**7.** Method according to claim 1 or 6, wherein the temperature sensors are directly connected to the printed circuit board without coordination of an external circuit.

**8.** Method according to claim 1 or 7, wherein when the electronic device is powered off, the temperature sensors will stop functioning.

**Patentansprüche**

**1.** Verfahren zum Detektieren einer Stromunterbrechungsdauer ($t_0$) einer elektronischen Vorrichtung, die mit wenigstens einem Temperatursensor zum Detektieren einer Temperatur der elektronischen Vorrichtung und wenigstens einem Temperatursensor zum Detektieren der Temperatur einer Leiterplatte versehen ist, wobei das Verfahren die folgenden Schritte umfasst:

(1) Erstellen eines Kurvenmodells linear synthetisierter Werte (ST) von Temperatursensorablesungen in Bezug auf die Zeit;
(2) Speichern des Kurvenmodells in einem internen Speicher eines Mikroprozessors;
(3) Übertragen jedes erlangten anfänglichen Temperaturwerts (aoi) von einem jeweiligen Temperatursensor nach dem Einschalten der elektronischen Vorrichtung über ein Analog-Digital-Umwandlungsmodul zu dem Mikroprozessor;
(4) Berechnen des diesmaligen linear synthetisierten Werts (ST) der elektronischen Vorrichtung mit dem in Schritt 1 erstellten gespeicherten Kurvenmodell und Speichern des linear synthetisierten Werts (ST) als Basis für die Berechnung der Stromunterbrechungsdauer ($t_0$) in dem Mikroprozessor; danach
(5) Übertragen jedes neuerlich durch die Temperatursensoren erlangten anfänglichen Temperaturwerts (aoi), wenn die elektronische Vorrichtung nach einer Stromunterbrechung erneut eingeschaltet wird, über das Analog-Digital-Umwandlungsmodul zu dem Mikroprozessor;
(6) Berechnen der diesmaligen Stromunterbrechungsdauer (t0) mit dem in Schritt 1 erstellten Kurvenmodell und auf Basis des in Schritt 4 berechneten in dem Mikroprozessor gespeicherten linear synthetisierten Werts (ST), und Speichern der diesmaligen Stromunterbrechungsdauer ($t_0$), während die diesmalige Einschaltdauer (Tp) durch den Mikroprozessor aufgezeichnet wird;
(7) Berechnen des diesmaligen linear synthetisierten Werts (ST), und Speichern des linear synthetisierten Werts (ST) als Basis für eine spätere erneute Berechnung der Stromunterbrechungsdauer ($t_0$) in dem Mikroprozessor,

**dadurch gekennzeichnet, dass**

das Kurvenmodell linear synthetisierter Werte (ST) der Temperatursensorablesungen in Bezug auf die Zeit als

$$ST = \sum_{i=1}^{n} k_1 \cdot \left[ a_{0i} + a_{1i}\left(1 - 1/e^{t/C_i}\right) \right]$$

dargestellt ist, wobei

ST ein linear synthetisierter Wert der Temperatursensorablesungen ist;
n eine Anzahl der Temperatursensoren ist, wobei $n \geq 2$ ist;
$k_i$ ein synthetisierter Koeffizient des Temperaturwerts ist; und $k_i$ so gesteuert wird, dass $-1 < k_i$ und $k_i \neq 0$ ist;
$a_{0i}$ ein durch einen Temperatursensor erlangter anfänglicher Temperaturwert ist;
$a_{1i}$ ein Skalierungsfaktor eines Temperatursorausgangs ist, und $a_{1i}$ so gesteuert wird, dass $-200 < a_{1i} < 200$ und $a_{1i} \neq 0$ ist;
$C_i$ eine Zeitkonstante ist, wobei $-1 \leq C \leq 10000$ ist; und
t eine Stromeinschaltdauer oder eine Stromunterbrechungsdauer ist, wobei die Stromeinschaltdauer durch $t_p$ dargestellt ist und die Stromunterbrechungsdauer durch $t_0$ dargestellt ist.

2. Verfahren nach Anspruch 1, wobei die Stromunterbrechungsdauer ($t_0$) als kritischer Wert bestimmt wird, wenn die Stromunterbrechungsdauer ($t_0$) größer als ein Vorgabewert ist.

3. Verfahren nach Anspruch 1 oder 2, wobei die Temperatursensoren an sich bewegenden Stellen und/oder wärmeerzeugenden Stellen der elektronischen Vorrichtung angebracht sind.

4. Verfahren nach einem der Ansprüche 2 bis 3, wobei der kritische Wert der Stromunterbrechungsdauer ($t_0$) zwischen 1,5 Stunden und 9 Stunden beträgt.

5. Verfahren nach einem der Ansprüche 1 bis 4, ferner umfassend den Schritt
des Schreibens des erstellten Kurvenmodells der linear synthetisierten Werte (ST) der Temperaturablesungen in Bezug auf die Zeit als Firmware in den Mikroprozessor.

6. Verfahren nach einem der Ansprüche 1 bis 5, ferner umfassend den Schritt
des Ausfilterns eines Störsignals, während eine diesmalige Stromeinschaltdauer ($t_p$) aufgezeichnet wird, durch Verarbeiten jedes erlangten anfänglichen Temperaturwerts (aoi).

7. Verfahren nach Anspruch 1 oder 6, wobei die Temperatursensoren ohne Koordination durch externe Schaltung direkt an die Leiterplatte angeschlossen sind.

8. Verfahren nach Anspruch 1 oder 7, wobei die Temperatursensoren ihre Funktion einstellen werden, wenn die elektronische Vorrichtung abgeschaltet ist.

**Revendications**

1. Procédé pour la détection d'une durée de coupure de courant ($t_0$) d'un dispositif électronique doté d'au moins un capteur de température chargé de détecter la température du d'une carte de circuit imprimé, le procédé comprenant les étapes suivantes:

(1) établissement d'un modèle de courbe de valeurs synthétisées linéairement (ST) de relevés du capteur de température en fonction du temps;
(2) stockage du modèle de courbe dans une mémoire interne du microprocesseur;
(3) transmission, après allumage du dispositif électronique, de chaque valeur de température initiale (aoi) acquise par un capteur de température respectif à un microprocesseur par le biais d'un module de conversion analogique à numérique;
(4) calcul de la valeur synthétisée linéairement (ST) du dispositif électronique pour cette période avec le modèle de courbe stocké dans l'étape 1, et stockage de la valeur synthétisée linéairement (ST) dans le microprocesseur comme base de calcul pour la durée de coupure de courant ($t_0$) par la suite;
(5) transmission, lorsque le dispositif électronique est allumé de nouveau après une coupure de courant, de chaque valeur de température initiale (aoi) acquise de nouveau par les capteurs de température au microprocesseur par le biais du module de conversion analogique à numérique;
(6) calcul de la durée de coupure de courant ($t_0$) pour cette période avec le modèle de courbe établi dans l'étape 1 et sur la base de la valeur synthétisée linéairement (ST) stockée dans le microprocesseur et calculée dans l'étape 4, et stockage de la durée de coupure de courant ($t_0$) pour cette période, tout en enregistrant la durée d'allumage (tp) pour cette période par le microprocesseur;
(7) calcul de la valeur synthétisée linéairement (ST) pour cette période, et stockage de la valeur synthétisée linéairement (ST) dans le microprocesseur comme base de calcul de la durée de coupure de courant ($t_0$) de nouveau par la suite,

**caractérisé en ce que**
le modèle de courbe de valeurs synthétisées linéairement (ST) de relevés de capteurs de température en fonction du temps est représenté de la manière suivante:

$$ST = \sum_{i=1}^{n} k_i \cdot [a_{0i} + a_{1i}(1 - 1/e^{(t/C_i)})]$$

où:

$ST$ est une valeur synthétisée linéairement des relevés de capteur de température ;
$n$ est un nombre des capteurs de température, $n \geq 2$;
$k_i$ est un coefficient synthétisé de la valeur de température ; et $k_i$ est commandé pour être

$$-1 < k_i < 1 \text{ et } k_i \neq 0;$$

$a_{0i}$ est une valeur de température initiale acquise par un capteur de température;
$a_{1i}$ est un facteur d'échelle d'une sortie de capteur de température, et $a_{1i}$ est commandé pour être

$$-200 < a_{1i} < 200 \text{ et } a_{1i} \neq 0;$$

$C_i$ est une constante de temps, $-1 \leq C \leq 10000$; et $t$ est une durée d'allumage ou une durée de coupure de courant, la durée d'allumage étant représentée par $t_p$, et la durée de coupure de courant étant représentée par $t_0$.

2. Procédé selon la revendication 1, dans lequel, lorsque la durée de coupure de courant ($t_0$) est supérieure à une valeur spécifique, la durée de coupure de courant ($t_0$) est désignée comme une valeur critique.

3. Procédé selon la revendication 1 ou 2, dans lequel les capteurs de température sont montés sur des emplacements mobiles et/ou des emplacements générateurs de chaleur sur le dispositif électronique.

4. Procédé selon l'une quelconque des revendications 2 à 3, dans lequel la valeur critique de la durée de coupure de courant ($t_0$) est comprise entre 1,5h et 9h.

5. Procédé selon l'une quelconque des revendications 1 à 4, comprenant en outre l'étape suivante:

   - écriture du modèle de courbe établi des valeurs synthétisées linéairement (ST) de relevés de capteurs de température en fonction du temps dans le microprocesseur en tant que micrologiciel.

6. Procédé selon l'une quelconque des revendications 1 à 5, comprenant en outre l'étape suivante:

   - filtrage d'un signal d'interférence pendant l'enregistrement d'une durée d'allumage ($t_p$) pour cette période en traitant chaque valeur de température initiale ($a_{0i}$) acquise.

7. Procédé selon la revendication 1 ou 6, dans lequel les capteurs de température sont directement reliés à la carte de circuit imprimé, sans coordination d'un circuit externe.

8. Procédé selon la revendication 1 ou 7, dans lequel, lorsque le dispositif électronique est éteint, les capteurs de température arrêtent de fonctionner.

Figure 1

Figure 2

Figure 3

| mechanical component | main shaft | main body | X-axis lead screw and nut | Y-axis lead screw and nut | Z-axis lead screw and nut |

displacement sensor | temperature sensor 2# | temperature sensor 3# | temperature sensor 4# | temperature sensor 5# | temperature sensor 6#

analog-to-digital conversion module

printed circuit board

temperature sensor 1#

power interruption duration detection module

internal memory

external memory

machine tool state diagnosis module

machine tool thermal error compensation module

microprocessor

motion control module

Figure 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0020931 A1